# EUROPEAN PATENT SPECIFICATION

(11) **EP 1 816 690 B1**
(45) Date of publication and mention of the grant of the patent: **01.07.2020**
(21) Application number: 07002205.8
(22) Date of filing: 01.02.2007
(51) Int. Cl.: H01L 51/50

(54) **OLED with area defined multicolor emission within a single lighting element**
OLED mit bereichsdefinierter mehrfarbiger Emission innerhalb eines Einzelbeleuchtungselements
Affichage électroluminescent organique (DELO) avec émission multicolore définie au sein d'un seul élément lumineux

(30) Priority: 01.02.2006 US 345835
(43) Date of publication of application: 08.08.2007
(73) Proprietor: OSRAM OLED GmbH, 93049 Regensburg (DE)
(72) Inventor: Choong, Vi-En, Carlsbad CA 92009 (US); Choulis, Stelios A., 90402 Nürnberg (DE); Mathai, Mathew K., Monroeville PA 15146 (US)
(74) Representative: Epping - Hermann - Fischer

(56) References cited:
- JP-A- 2003 123 971
- US-A- 5 693 428
- US-A1- 2001 022 496
- US-A1- 2003 030 370
- DATABASE INSPEC [Online] THE INSTITUTION OF ELECTRICAL ENGINEERS, STEVENAGE, GB; 2000, HSIN-HUA CHANG ET AL: "Multicolor organic LEDs processed by integration of screen printing and thermal transfer printing", XP1032494, Database accession no. 6958936 & DISPLAY TECHNOLOGIES III 26-27 JULY 2000 TAIPEI, TAIWAN, vol. 4079, 26 July 2000 (2000-07-26), pages 127-134, Proceedings of the SPIE - The International Society for Optical Engineering SPIE-Int. Soc. Opt. Eng. USA ISSN: 0277-786X, DOI: DOI:10.1117/12.389398

## Description

### BACKGROUND

### 1. Field of the Invention

This invention relates generally to the art of thin film device processing and fabrication. More specifically, the invention relates to the structure of Organic Light Emitting Diode devices and displays.

### 2. Related Art

White light emitting panels by means of organic light emitting diodes (OLEDs) are being researched as future low power consumption lighting solutions. In order to generate white light from the constituent wavelengths to cover the visible spectrum, typically multiple emitters are used in these panels. One method involves the use of pixilation of the OLED panel with individual pixels based on emission from individual emitters. The total light emission from the panel thus is made up of emission from different wavelengths and appears to be white. This methodology involves expensive patterning techniques for both the organic layers as well as the electrodes used to address the individual OLED pixels.

JP2003123971 A discloses an organic electroluminescent element with light emitting layers, wherein at least one of the two layers is pattern-arranged on the same plane.

HSIN-HUA CHANG ET AL: "Multicolor organic LEDs processed by integration of screen printing and thermal transfer printing", DISPLAY TECHNOLOGIES III, 26-27 JULY 2000 TAIPEI, TAIWAN, vol. 4079 (2000), pages 127-134, Proceedings of the SPIE - The International Society for Optical Engineering, teaches multicolor organic LEDs having a matrix made of PVK, which is doped with dopants, i.e. emitters, such as coumarine6 and perylene in order to obtain regions which emit light of different colors.

US2001/022496 A1 discloses an organic electroluminescent white light source with a substrate, electrodes and light emitting layers, such as a blue emitting host layer, which can be doped in order to achieve regions with different light emitting properties.

US5693428 A teaches OLEDs with a substrate, electrodes and a luminescent layer having luminescent portions with different emission properties.

JP07220871 discloses an organic electroluminescent device comprising at least a hole transport layer and an electron transport light emitting layer, wherein the light emitting layer comprises at least one dye dispersed in a polymer to constitute a white light emitting layer.

### BRIEF DESCRIPTION OF THE DRAWINGS

FIG. 1 shows a cross-sectional view of an embodiment of an electroluminescent (EL) device 205 according to at least one embodiment of the invention.
FIG. 2 shows a cross-sectional view of exemplary EL device in accordance with at least one embodiment of the invention.
FIG. 3 illustrates a top view of a composite light emissive layer utilized in a lighting element.

### DETAILED DESCRIPTION

An approach is disclosed which enables the generation of white light from organic electroluminescent devices. The approach involves the surface patterning of a single composite organic light emissive layer in the OLED with emitters luminescing at different wavelengths. The combined emission thus obtained from the composite light emissive layer emitting different colors covers the visible spectrum in such a way so as to generate light of the desired color. Furthermore, the light emissive materials within the composite layer utilize a common cathode and anode, circumventing expensive electrode patterning techniques. This type of electroluminescence is a cost reducing way to obtain white light emitting surfaces while maintaining the intrinsic efficiency of the device from the constituent colors of emission.

Furthermore, different emitter materials, which emit light at different wavelengths can be deposited within the composite light emissive layer in differing patterns thereby creating static, multicolored icons in the electroluminescent device.

In one or more embodiments of the invention, what is disclosed is a novel electroluminescent (EL) device including a composite light emissive layer comprising a first emissive material and at least one additional emissive material which is patterned on/into the surface of the first emissive material. All of the color emitting regions of the composite light emissive layer is singularly addressable by two electrodes in the EL device. In some examples, at least one additional emissive material is embedded into or forms a sublayer within the first emissive material giving more than one color emitting region. In some embodiments, the regions form a repeating pattern. The EL device in some embodiments is a lighting element designed to provide uniform light emission such as in the case of area lighting using white or monochrome color schemes. In further examples the EL device is designed to provide static, multicolored icons.

In accordance with some examples not forming part of the invention, the composite light emissive layer can be comprised of a first blue emissive material deposited as a uniform film or layer and a second green emissive material which is deposited in a pattern over the film or layer and a third red emissive material which is deposited in yet another pattern upon the first and second emissive material. The deposited red and/or green materials can further be 'driven into' the underlying blue emitting layer. The composite light emissive layer is singularly addressed and activated by a pair of electrodes which can be arranged in a stack as shown in the accompanying figures. The EL device may also contain charge injection, charge transport, charge blocking and encapsulation layers or combinations of them within one layer as needed and is preferably built upon a common substrate. For example, the combination of hole transport and electron blocking layer may comprise materials such as PANI (Polyaniline), PEDOT (Poly(3,4-ethylene-dioxythiophene)) and PSS (Polystyrene sulfonate). Furthermore, the EL device may comprise an anode buffer layer for enhancing hole injection and planarizing the device.

One method to fabricate an EL device in accordance with at least one embodiment of the invention is to first fabricate a light emissive film or layer which is, for example, blue emitting. This film can be spin coated or vapor deposited on a single large electrode, for example, a transparent ITO anode. This blue emitting film or layer can then be patterned to obtain regions where green and red emissive materials can be disposed. This would be followed by the deposition of a single large cathode. The color of light generated is determined by the efficiency of the individual color emissive regions, and the relative area comprised of each region. Thus expensive patterning of pixilated electrodes is avoided. Alternatively and according to the invention, a non-emitting matrix layer is spin coated on first. Then the emitter and moieties needed to obtain the different spectrums are embedded into the non-emitting matrix layer. In this case, combinations of red, green, and blue or cyan and orange are examples.

The method of patterning used can be different and include, for example PDMS stamps, spinning of solvent containing the emitter molecules, ink-jetting of patterns, vapor deposition or any other printing method. Furthermore other moieties required for the localized region of the pattern such as charge transport molecules are also diffused in to enhance the device performance in the region modified by the printing or deposition technique.

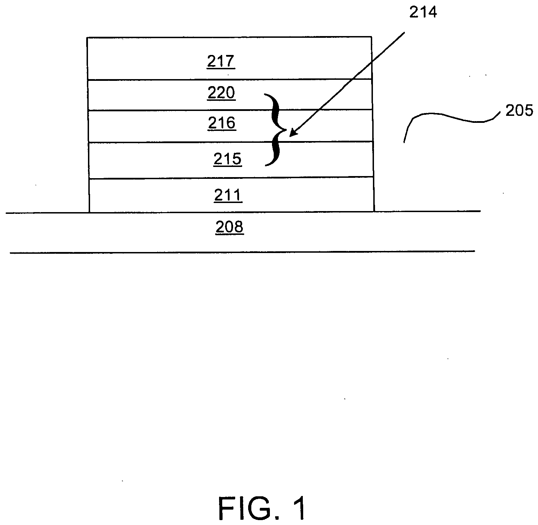

FIG. 1 shows a cross-sectional view of an embodiment of an electroluminescent (EL) device 205 according to at least one embodiment of the invention. OLED device 205 includes substrate 208 and a first electrode 211 on the substrate 208. The OLED device 205 also includes a semiconductor stack 214 on the first electrode 211. The semiconductor stack 214 includes at least the following: (1) an anode buffer layer (ABL) 215 and (2) a composite light emissive (emissive) layer (CEML) 216.

As shown in FIG. 1, the OLED device 205 is a bottom-emitting device. As a bottom-emitting device, the first electrode 211 would act as an anode, and the ABL 215 would be disposed on the first electrode 211, the CEML 216 would be fabricated over the ABL 215 followed by a second electrode 217 (cathode) fabricated over the semiconductor stack 214. Other layers than that shown in FIG. 1 may also be added such as insulating layers, barrier layers, electron/hole injection and blocking layers, getter layers, and so on. Exemplary embodiments of some of these layers are described in greater detail below.

### Substrate 208:

The substrate 208 can be any material, which can support the additional layers and electrodes, and is transparent or semi-transparent to the wavelength of light emitted by the OLED device 205. Preferable substrate materials include glass, quartz, silicon, and plastic, preferably, thin, flexible glass. The preferred thickness of the substrate 208 depends on the material used and on the application of the device. The substrate 208 can be in the form of a sheet or continuous film.

The continuous film is used, for example, for roll-to-roll manufacturing processes which are particularly suited for plastic, metal, and metallized plastic foils.

### First Electrode 211:

In the bottom-emitting configuration, the first electrode 211 functions as an anode (the anode is a conductive layer which serves as a hole-injecting layer). Typical anode materials include metals (such as platinum, gold, palladium, indium, and the like); metal oxides (such as lead oxide, tin oxide, indium-tin oxide, and the like); graphite; doped inorganic semiconductors (such as silicon, germanium, gallium arsenide, and the like); and doped conducting polymers (such as polyaniline, polypyrrole, polythiophene, and the like). Preferably, the first electrode 211 is comprised of indium-tin oxide (ITO).

The first electrode 211 is preferably transparent or semi-transparent to the wavelength of light generated by the OLED device 205. Preferably, the thickness of the first electrode 211 is from about 10 nanometers ("nm") to about 1000 nm, more preferably from about 50 nm to about 200 nm, and most preferably is about 100 nm to 150 nm.

The first electrode layer 211 can typically be fabricated using any of the techniques known in the art for deposition of thin films, including, for example, vacuum evaporation, sputtering, electron beam deposition, or chemical vapor deposition, using for example, pure metals or alloys, or other film precursors.

### ABL 215:

The ABL 215 has good hole conducting properties and is used to effectively inject holes from the first electrode 211 to the CEML 216. The ABL 215 is made of polymers or small molecule materials or other organic or partially organic material. For example, the ABL 215 can be made from tertiary amine or carbazole derivatives both in their small molecule or their polymer form, conducting polyaniline ("PANI"), or PEDOT:PSS (a solution of poly(3,4-ethylenedioxythiophene) ("PEDOT") and polystyrenesulfonic acid ("PSS") (available as Baytron P from HC Starck). The ABL 215 can have a thickness from about 5 nm to about 1000 nm, and is conventionally used from about 50 to about 250 nm.

Other examples of the ABL 215 include any small molecule materials and the like such as plasma polymerized fluorocarbon films (CFx) with preferred thicknesses between 0.3 and 3 nm, copper pthalocyanine (CuPc) films with preferred thicknesses between 10 and 50 nm.

The ABL 215 can be formed using selective deposition techniques or nonselective deposition techniques. Examples of selective deposition techniques include, for example, ink jet printing, flex printing, and screen printing. Examples of nonselective deposition techniques include, for example, spin coating, dip coating, web coating, and spray coating. A hole transporting and/or buffer material is deposited on the first electrode 211 and then allowed to dry into a film. The dried film represents the ABL 215. Other deposition methods for the ABL 215 include plasma polymerization (for CFx layers), vacuum deposition, or vapor phase deposition (e.g. for films of CuPc).

### CEML 216:

A composite light emissive layer (CEML) 216 is comprised of a plurality of electroluminescent materials which emit light upon application of a potential across first electrode 211 and second electrode 217 or by other excitation. The CEML may be fabricated from materials organic or organo-metallic in nature such as monomers, oligomers, small molecules and polymers. As used herein, the term organic also includes organo-metallic materials. Light-emission in these materials may be generated as a result of fluorescence or phosphorescence. A plurality of light emissive materials emitting in different color spectrums are combined by stamping, printing, vapor deposition, other deposition processes or any combination of said techniques to form CEML 216. For example, a blue emitting polymer material can be stamped with red and green emitting dyes to yield a whitish emission from CEML 216. Examples of light emissive materials that can be used in CEML 216 include:
(i) poly(p-phenylene vinylene) and its derivatives substituted at various positions on the phenylene moiety;
(ii) poly(p-phenylene vinylene) and its derivatives substituted at various positions on the vinylene moiety;
(iii) poly(p-phenylene vinylene) and its derivatives substituted at various positions on the phenylene moiety and also substituted at various positions on the vinylene moiety;
(iv) poly(arylene vinylene), where the arylene may be such moieties as naphthalene, anthracene, furylene, thienylene, oxadiazole, and the like;
(v) derivatives of poly(arylene vinylene), where the arylene may be as in (iv) above, and additionally have substituents at various positions on the arylene;
(vi) derivatives of poly(arylene vinylene), where the arylene may be as in (iv) above, and additionally have substituents at various positions on the vinylene;
(vii) derivatives of poly(arylene vinylene), where the arylene may be as in (iv) above, and additionally have substituents at various positions on the arylene and substituents at various positions on the vinylene;
(viii) co-polymers of arylene vinylene oligomers, such as those in (iv), (v), (vi), and (vii) with non-conjugated oligomers; and
(ix) poly(p-phenylene) and its derivatives substituted at various positions on the phenylene moiety, including ladder polymer derivatives such as poly(9,9-dialkyl fluorene) and the like;
(x) poly(arylenes) where the arylene may be such moieties as naphthalene, anthracene, furylene, thienylene, oxadiazole, and the like; and their derivatives substituted at various positions on the arylene moiety;
(xi) co-polymers of oligoarylenes such as those in (x) with non-conjugated oligomers;
(xii) polyquinoline and its derivatives;
(xiii) co-polymers of polyquinoline with p-phenylene substituted on the phenylene with, for example, alkyl or alkoxy groups to provide solubility;
(xiv) rigid rod polymers such as poly(p-phenylene-2,6-benzobisthiazole), poly(p-phenylene-2,6-benzobisoxazole), poly(p-phenylene-2,6-benzimidazole), and their derivatives; and
(xv) polyvinyl carbazole, or other non-conjugated polymers.

Other organic emissive polymers such as those utilizing polyfluorene include that emit green, red, blue, or white light or their families, copolymers, derivatives, or mixtures thereof. Other polymers include polyspirofluorene-like polymers, their families, co-polymers and derivatives. Alternatively, rather than polymers or even in combination with polymers, small organic molecules that emit by fluorescence or by phosphorescence can serve as the organic electroluminescent layer or be a part of the composite light emissive layer. Examples of small-molecule organic electroluminescent materials include: :
(i) tris(8-hydroxyquinolinato) aluminum (Alq3);
(ii) 1,3-bis(N,N-dimethylaminophenyl)-1,3,4-oxidazole (OXD-8);
(iii) -oxo-bis(2-methyl-8-quinolinato)aluminum;
(iv) bis(2-methyl-8-hydroxyquinolinato) aluminum;
(v) bis(hydroxybenzoquinolinato) beryllium (BeQ.sub.2);
(vi) bis(diphenylvinyl)biphenylene (DPVBI); and
(vii) arylamine-substituted distyrylarylene (DSA amine).
The CEML 216 can emit light in any desired color and be comprised of polymers, co-polymers, dyes, nano-particles, small molecules, dopants, quenchers, and hole transport materials or any combinations thereof as desired. Additionally, it can emit light in different colors depending on the density of pattern of different light emissive materials in the composite light emissive layer.

In addition light emissive materials may comprise phosphorescent or fluoresenct dyes, either organic or inorganic. For instance, the light emissive materials used may include a dye such as, for example, an organic fluorescent dye (for example perylene and coumarin). Other exemplary spectrum converting materials which could be used as or in addition to light emissive materials include, for example, cerium doped garnets, nitride phosphors, ionic phosphors like SrGa2S4:Eu2+ or SrS:Eu2+, or quantum dots.

The thickness of the CEML 216 can be from about 5 nm to about 500 nm, preferably, from about 20 nm to about 100 nm, and more preferably is about 75 nm. The method of patterning the various light emitting materials used can be different and include, for example PDMS stamps, spinning of solvent containing the emitter molecules, ink-jetting of patterns or any other printing method and vapor deposition. Furthermore other moieties required for the localized region of the pattern such as charge transport molecules are also diffused in to enhance the device performance in the region modified by the printing technique.

Thus, in addition to light emissive materials, CEML 216 also includes materials capable of charge transport. Charge transport materials include polymers or small molecules that can transport charge carriers. For example, organic materials such as polythiophene, derivatized polythiophene, oligomeric polythiophene, derivatized oligomeric polythiophene, pentacene, triphenylamine, and triphenyldiamine. CEML 216 may also include semiconductors, such as silicon, gallium arsenide, cadmium selenide, or cadmium sulfide.

According to the invention, the CEML 216 is fabricated by first depositing a non-emitting matrix layer (for instance, of polymethylmethacrylate or polycarbonate or polyvinyl carbazole) and then embedding the various emissive materials within the matrix in a patterned or unpatterned fashion. In this way, each emitting area has the transport materials, and other constituents optimized for that particular emitter. The transport materials for each emitter are different.

### Second Electrode 217:

In the bottom-emitting configuration, the second electrode 217 functions as a cathode (the cathode is a conductive layer which serves as an electron-injecting layer and which comprises a material with a low work function). While the second electrode can be comprised of many different materials, preferable materials include aluminum, silver, gold, magnesium, calcium, cesium, barium, or combinations thereof. More preferably, the cathode is comprised of aluminum, aluminum alloys, or combinations of magnesium and silver. Additional cathode materials may contain fluorides such as LiF and the like. Second electrode 217 though shown as a single layer may be composed of a plurality of sub-layers composed of one or more of the above materials in any desirable combination.

The thickness of the second electrode 217 is from about 10 nm to about 1000 nm, preferably from about 50 nm to about 500 nm, and more preferably, from about 100 nm to about 300 nm. While many methods are known to those of ordinary skill in the art by which the second electrode 217 may be deposited, vacuum deposition and sputtering methods are preferred.

A device not according to the invention was fabricated as follows. A large area pixel defined on an ITO coated (anode) glass substrate was utilized. A 60 nm PEDOT layer (anode buffer layer) was spin coated over it. This was followed by a blue light emitting polymer (LEP) film. Then a stamp which was precoated with green dye was used. The stamp was placed on top of the blue LEP and the green dye was 'driven in' to the blue LEP in certain defined regions. This was followed by a stamp with a red dye. Thus a composite layer of a blue LEP with patterns of red and green regions was obtained. This was followed by the evaporation of a single large cathode. The light obtained from the device is a combination of the emitting colors. Thus, a cost-effective 'white light' source is obtained.

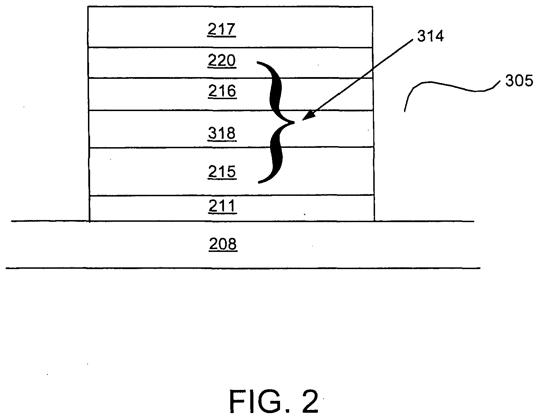

FIG. 2 shows a cross-sectional view of an embodiment of an electroluminescent (EL) device 305 according to at least one embodiment of the invention. Device 305 is similar or identical to device 205 in all aspects with like-numbered elements having the same or similar descriptions, except for the following. A semiconductor stack 314 comprises at least three layers CEML 216, a hole transporting (HT) interlayer 318 and an anode buffer layer (ABL) 215.

### HT interlayer 318:

The functions of the HT interlayer 318 are among the following: to assist injection of holes into the CEML 216, reduce exciton quenching, provide better hole transport than electron transport, and block electrons from getting into the ABL 215 and degrading it. Some materials may have one or two of the desired properties listed, but the effectiveness of the material as an interlayer is believed to improve with the number of these properties exhibited. The HT interlayer 318 may consist at least partially of or may derive from one or more following compounds, their derivatives, moieties, etc: polyfluorene derivatives, poly(2,7-(9,9-di-n-octylfluorene)-(1,4-phenylene-((4-secbutylphenyl)imino)-1,4-phenylene) and derivatives which include cross-linkable forms, non-emitting forms of poly(p-phenylenevinylene), triarylamine type material (e.g. triphenyldiamine (TPD), α-napthylphenyl-biphenyl (NPB)) mixed with a crosslinkable small molecule or polymer matrix, thiopene, oxetane-functionalized polymers and small molecules etc. The hole transporting materials used in the HT interlayer 318 are preferably polymer hole transporting materials, but can be small molecule hole transporting materials with a polymer binder. For example, polymers containing aromatic amine groups in the main chain or side chains are widely used as hole transporting materials. Preferably, the thickness for the HT interlayer 318 is 10-150 nm. More preferably the thickness for the HT interlayer 318 is 20-60 nm. In some examples, the HT interlayer 318 is fabricated using a cross-linkable hole transporting polymer.

The interlayer 318 may also include one or more organic and/or inorganic conductivity dopants. In one or more examples, inorganic conductivity dopants comprise, for example, at least one of the following: ferric chloride (FeCl₃), ferric bromide (FeBr₃), antimony pentachloride (SbCl₅), arsenic pentachloride(AsCl₅), boron trifluoride (BF₃), etc. In one or more examples, organic conductivity dopants comprise, for example, at least one of the following: 2,3,5,6-tetrafluoro-7,7,8,8-tetracyano-quinodimethane (F4-TCNQ), dicyanodichloroquinone, and trinitrofluorenone, etc.

The HT interlayer 318 is preferably cross-linked or otherwise physically or chemically rendered insoluble to prevent degradation of the HT interlayer 318 when exposed to the solvent used in fabrication of subsequent adjacent layers such as the CEML 216. Cross-linking can be achieved by exposing the film or deposited solution of HT interlayer 318 to light, ultraviolet radiation, heat, or by chemical process. This may include the use of ultraviolet curable inks, crosslinkable side chains, crosslinkable chain end groups, monomers which can be cross-linked into polymers, cross-linking agents, initiators, polymer blends, polymer matrices and so on. The general process(s) of cross-linking organic materials is well-known, and will not be described further. As one possible alternative to cross-linking, the HT interlayer 318 can be rendered insoluble by adjusting its polarity in accordance with the polarity of the solvent (e.g. toluene, xylene etc.) that is to be used in fabricating the CEML 216. The HT interlayer 318 can be fabricated prior to or in conjunction with the cross-linking process by ink-jet printing, by spin-coating or other proper deposition techniques.

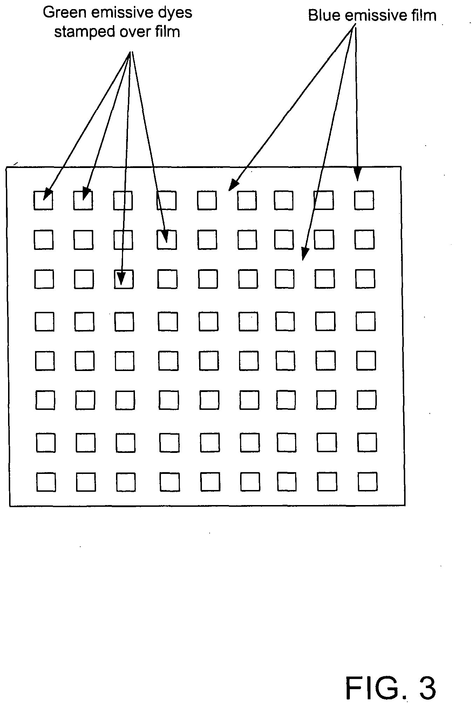

FIG. 3 illustrates a top view of a composite light emissive layer utilized in a lighting element. A blue emissive film is shown. Over the blue emissive film, a green dye was stamped in creating a pattern of square green emissive regions. These green emissive regions may be above the underlying blue emissive film or embedded therein. Additional emissive materials may be stamped or printed in a similar fashion.

The OLED display/device described earlier can be used within displays in applications such as, for example, computer displays, information displays in vehicles, television monitors, telephones, printers, and illuminated signs and in lighting applications for white and colored lighting, residential and general area lighting, back light applications, and industrial lighting. In lighting it is expected that due to the 'unsaturated' color of the device as described herein, color tuning along the Plankian curve (required for high color rendering index) can easily be achieved by utilizing a combination of different unsaturated color emitting OLED devices. Also, in such devices while the emission is comprised of a combination of colors, locally the patterned region within the device is still emitting a single color. Conventionally, in the field of OLEDs, emission from a single emitting moiety within a device allows for the best device efficiency, often exceeding that of combined emitters. The present invention circumvents the need for individual saturated pixels to obtain a range of colors. At the same time, as locally the emission is in fact from a single color none of the efficiency is lost.

## Claims

1. An organic electroluminescent device (205, 305) generating white light comprising:
a substrate (208);
a first electrode (211) disposed over the substrate;
a composite light emissive layer (216), disposed over the first electrode, said composite light emissive layer comprising a first light emissive material and at least one additional light emissive material, the additional light emissive material emitting in a different spectrum than said first light emissive material and wherein the composite light emissive layer further comprises a non-emitting matrix layer, said first light emissive material and a corresponding charge transport material and said at least one additional light emissive material and a corresponding charge transport material being embedded into said non-emitting matrix layer, wherein said charge transport materials are different for each light emissive material; and
a second electrode (217) disposed over said composite light emissive layer, further wherein said second electrode and said first electrode are common to and address the entirety of said composite light emissive layer.

2. The device according to claim 1 further comprising: an anode buffer layer (215) between the first electrode and the composite light emissive layer.

3. The device according to claim 1 wherein the first electrode (211) comprises a hole injecting electrode.

4. The device according to claim 1 wherein the second electrode (217) comprises an electron injecting electrode.

5. The device according to claim 2 further comprising:
a hole transporting interlayer (318) disposed between said anode buffer layer (215) and said composite light emissive layer (216).

6. The device according to claim 1 wherein said at least one additional light emissive material is a dye.

7. The device according to claim 1 wherein said first light emissive material is a polymer.

8. The device according to claim 1 wherein said first light emissive material is a small molecule.

9. The device according to claim 1 wherein said first light emissive material emits in at least one of yellow, blue, green, red, cyan and orange.

10. The device according to claim 1 wherein said at least one additional light emissive material emits in at least one of yellow, blue, green, red, cyan and orange.

11. The device according to claim 1 wherein said first light emissive material emits in blue.

12. The device according to claim 11 wherein said at least one additional emissive material comprises one emissive material emitting in green and another emissive material emitting in red.

13. The device according to claim 1 wherein said organic electroluminescent device (205, 305) is a lighting element.

14. The device according to claim 1 wherein said non-emitting matrix layer comprises non-conjugated polymers.

15. The device according to one of the preceding claims, wherein the non-emitting matrix layer comprises polymethylmethacrylate or polycarbonate.

## Patentansprüche

1. Eine organische Elektrolumineszenzvorrichtung (205, 305), die weißes Licht erzeugt, umfassend:
ein Substrat (208);
eine erste Elektrode (211), die über dem Substrat angeordnet ist;
eine lichtemittierende Verbundschicht (216), die über der ersten Elektrode angeordnet ist, die lichtemittierende Verbundschicht ein erstes lichtemittierendes Material und mindestens ein zusätzliches lichtemittierendes Material umfasst, das zusätzliche lichtemittierende Material in einem anderen Spektrum emittiert als das erste lichtemittierende Material und wobei die lichtemittierende Verbundschicht weiter eine nicht-emittierende Matrixschicht umfasst, das erste lichtemittierende Material und ein entsprechendes Ladungstransportmaterial und das mindestens eine zusätzliche lichtemittierende Material und ein entsprechendes Ladungstransportmaterial in die nicht-emittierende Matrixschicht eingebettet sind,
wobei die Ladungstransportmaterialien für jedes lichtemittierende Material unterschiedlich sind; und
eine zweite Elektrode (217 über der lichtemittierenden Verbundschicht angeordnet ist, wobei die zweite Elektrode und die erste Elektrode gemeinsam sind und die Gesamtheit der lichtemittierenden Verbundschicht adressieren.

2. Die Vorrichtung nach Anspruch 1, weiter umfassend: eine Anodenpufferschicht (215) zwischen der ersten Elektrode und der lichtemittierenden Verbundschicht.

3. Die Vorrichtung nach Anspruch 1, wobei die erste Elektrode (211) eine Lochinjektionselektrode umfasst.

4. Die Vorrichtung nach Anspruch 1, wobei die zweite Elektrode (217) eine Elektroneninjektionselektrode umfasst.

5. Die Vorrichtung nach Anspruch 2, wobei die Vorrichtung nach Anspruch 2 weiter umfasst:
eine lochtransportierende Zwischenschicht (318), die zwischen der Anodenpufferschicht (215) und der lichtemittierenden Verbundschicht (216) angeordnet ist.

6. Die Vorrichtung nach Anspruch 1, wobei das mindestens eine zusätzliche lichtemittierende Material ein Farbstoff ist.

7. Die Vorrichtung nach Anspruch 1, wobei das erste lichtemittierende Material ein Polymer ist.

8. Die Vorrichtung nach Anspruch 1, wobei das erste lichtemittierende Material ein kleines Molekül ist.

9. Die Vorrichtung nach Anspruch 1, wobei das erste lichtemittierende Material in mindestens einer der Farben Gelb, Blau, Grün, Rot, Cyan und Orange emittiert.

10. Die Vorrichtung nach Anspruch 1, wobei das mindestens eine zusätzliche lichtemittierende Material in mindestens einer der Farben Gelb, Blau, Grün, Rot, Cyan und Orange emittiert.

11. Die Vorrichtung nach Anspruch 1, wobei das erste lichtemittierende Material in Blau emittiert.

12. Die Vorrichtung nach Anspruch 11, wobei das mindestens eine zusätzliche lichtemittierende Material ein lichtemittierendes Material, das in Grün emittiert, und ein weiteres lichtemittierendes Material, das in Rot emittiert, umfasst.

13. Die Vorrichtung nach Anspruch 1, wobei die organische Elektrolumineszenzvorrichtung (205, 305) ein Beleuchtungselement ist.

14. Die Vorrichtung nach Anspruch 1, wobei die nicht-emittierende Matrixschicht nicht-konjugierte Polymere umfasst.

15. Die Vorrichtung nach einem der vorhergehenden Ansprüche, wobei die nicht-emittierende Matrixschicht Polymethylmethacrylat oder Polycarbonat umfasst.

## Revendications

1. Un dispositif électroluminescent organique (205, 305) générant une lumière blanche comprenant :
un substrat (208) ;
une première électrode (211) disposée sur le substrat ;
une couche composite émettrice de lumière (216), disposée sur la première électrode, ladite couche composite émettrice de lumière comprenant un premier matériau émetteur de lumière et au moins un matériau émetteur de lumière supplémentaire, le matériau émetteur de lumière supplémentaire émettant dans un spectre différent de celui du premier matériau émetteur de lumière et dans lequel la couche composite émettrice de lumière comprend en outre une couche de matrice non émettrice, le premier matériau émetteur de lumière et un matériau de transport de charge correspondant, ainsi qu'au moins un matériau émetteur de lumière supplémentaire et un matériau de transport de charge correspondant étant incorporés à ladite couche de matrice non émettrice,
dans lequel lesdits matériaux de transport de charge étant différents pour chaque matériau émetteur de lumière ; et
une deuxième électrode (217) disposée sur ladite couche composite émettrice de lumière, la deuxième électrode et la première électrode étant en outre communes à la couche composite émettrice de lumière et s'adressant à la totalité de celle-ci.

2. Dispositif selon la revendication 1, comprenant en outre : une couche tampon anodique (215) entre la première électrode et la couche composite émettrice de lumière.

3. Dispositif selon la revendication 1, dans lequel la première électrode (211) comprend une électrode d'injection de trous.

4. Dispositif selon la revendication 1, dans lequel la seconde électrode (217) comprend une électrode d'injection d'électrons.

5. Dispositif selon la revendication 2 comprenant en outre :
une couche intermédiaire de transport de trous (318) disposée entre la couche tampon anodique (215) et la couche composite émettrice de lumière (216).

6. Dispositif selon la revendication 1, dans lequel au moins un matériau émetteur de lumière supplémentaire est une teinture.

7. Dispositif selon la revendication 1, dans lequel le premier matériau émetteur de lumière est un polymère.

8. Dispositif selon la revendication 1, dans lequel le premier matériau émetteur de lumière est une petite molécule.

9. Dispositif selon la revendication 1, dans lequel le premier matériau émetteur de lumière émet dans au moins l'une des couleurs suivantes : jaune, bleu, vert, rouge, cyan et orange.

10. Dispositif selon la revendication 1, dans lequel au moins un matériau supplémentaire émetteur de lumière émet dans au moins l'une des couleurs suivantes : jaune, bleu, vert, rouge, cyan et orange.

11. Dispositif selon la revendication 1, dans lequel le premier matériau émetteur de lumière émet en bleu.

12. Dispositif selon la revendication 11, dans lequel au moins un matériau émetteur supplémentaire comprend un matériau émetteur émettant en vert et un autre matériau émetteur émettant en rouge.

13. Dispositif selon la revendication 1, dans lequel le dispositif électroluminescent organique (205, 305) est un élément d'éclairage.

14. Dispositif selon la revendication 1, dans lequel la couche de matrice non émettrice comprend des polymères non conjugués.

15. Dispositif selon l'une des revendications précédentes, dans lequel la couche de matrice non émettrice comprend du polyméthacrylate de méthyle ou du polycarbonate.
